# EUROPEAN PATENT APPLICATION

(11) **EP 4 557 590 A1**
(43) Date of publication of application: **21.05.2025**
(21) Application number: 23209937.4
(22) Date of filing: 14.11.2023
(51) Int. Cl.: H02K 15/03

(54) **APPARATUS AND METHOD FOR INDICATING POLARITY OF A MOTOR ROTOR**

(71) Applicant: Ford Global Technologies, LLC, Dearborn, MI 48126 (US)
(72) Inventor: ETCHES, Mickey Kevin, Basildon, SS15 6BW (GB)
(74) Representative: Haley Guiliano International LLP

(57) **Abstract**

The present disclosure relates to an apparatus and method for indicating the polarity of the motor rotor. The apparatus comprises a sleeve and a disc. The sleeve receives a motor rotor. The disc comprises a cavity and an indication assembly. The cavity receives the sleeve. The indication assembly is arranged on the periphery of the cavity. The indication assembly includes a slot to receive a movable magnet. The moveable magnet comprises one or more polarity markings to visually indicate polarity of the motor rotor.

## Description

### Background

The present disclosure relates to an indication apparatus. Particularly, but not exclusively, the present disclosure relates to an apparatus and a method to indicate polarity of a motor rotor for enhancing user experience.

### Summary

Nowadays, an electric motor plays a vital role in automotive applications. A rotor is a crucial component of the motor that is responsible for converting electrical energy into mechanical energy. During manufacture of a powertrain drive unit (PDU), the rotor of the motor is provided initially in an unmagnetized state. Later on, the rotor is magnetized in a purpose-built machine prior to assembly of the PDU. In one approach, a Gauss meter can be used to check the magnetization of the rotor. However, such an approach can be onerous. A need, therefore, exists to provide an apparatus and a method to enable quick and reliable checking of a motor rotor to ensure that the motor rotor has been magnetized in the manner intended.

An object of the present disclosure is to provide an apparatus and a method to enhance a procedure of checking the magnetization of a motor rotor.

Another object of the present disclosure is to provide an apparatus and a method that can limit the use of conventional Gauss meters when checking the magnetization of a motor rotor. As a result, the number of people and/or time required to check the magnetization of a motor rotor can be reduced.

Another object of the present disclosure is to provide a user-friendly and efficient apparatus and method for use during the manufacture and assembly of PDU, e.g., for use in electric vehicles.

According to the apparatus and method, described herein, there is provided an apparatus comprising a sleeve and a disc. The sleeve receives a motor rotor. The disc comprises a cavity and an indication assembly. The cavity receives the sleeve. The indication assembly is arranged on the periphery of the cavity. The indication assembly includes a slot to receive a movable magnet. The moveable magnet comprises one or more markings to visually indicate a magnetization state, e.g., a polarity, of magnets of the motor rotor, e.g., when the rotor is received in the sleeve and the sleeve is received in the cavity of the disc. In some examples, the motor rotor may be fixed in position within the sleeve and the disc may be configured to move, e.g., rotationally and/or axially, relative to the sleeve. In this manner, the magnetization of magnets contained within the motor can be checked by moving the disc relative to the sleeve-rotor subassembly and observing the movement of the moveable magnet within the slot. Therefore, the use of other equipment, such as a Gauss meter is not required when checking whether the rotor has been magnetized in an expected manner.

In some examples, the slot includes an inner end arranged in proximity to the cavity and an outer end arranged distant from the cavity.

In some examples, the slot enables the moveable magnet to move from the inner end to the outer end.

In some examples, the movable magnet moves by virtue of magnetic field of the motor rotor.

In some examples, the slot includes a lower end to place the moveable magnet and an upper end.

In some examples, the upper end of the slot comprises one or more indication windows to enable visibility of the one or more polarity markings of the moveable magnet.

In some examples, the indication window is arranged to indicate the polarity marking opposite to the polarity of the moveable magnet at the inner end, if the moveable magnet is attracted by the motor rotor.

In some examples, the indication window is arranged to indicate the polarity marking same as the polarity of the moveable magnet at the inner end, if the moveable magnet is repelled by the motor rotor.

In some examples, the sleeve includes an upper end and a lower end to receive and enclose the motor rotor lengthwise. The sleeve may be sized and/or shaped internally so as to slidably receive the rotor. The sleeve may be sized and/or shaped externally to match an internal size and/or shape of the cavity of the disc.

In some examples, the disc is slidable between the upper end and the lower end of the sleeve to enable visual indication of the polarity of the motor rotor lengthwise.

According to the foregoing examples, the visual indication enables a user or operator to perform checking of the polarity of the motor rotor. Hence, increasing the efficiency to perform the overall operation as compared to the conventional methods. As a result, the overall user experience may be enhanced.

According to the apparatus, method, and system described herein, there is provided a method. The method comprises receiving a motor rotor in a sleeve; receiving the sleeve in a cavity of a disc; and providing a visual indication of polarity of the motor rotor using an indication assembly arranged on the periphery of the cavity; wherein the indication assembly includes a slot to receive a moveable magnet with one or more magnetization state, e.g., polarity, markings. In some examples, the method comprises fixing the position of the rotor within the sleeve. In some examples, the method comprises moving the disc, e.g., axially and/or rotationally, relative to the sleeve-rotor subassembly. In some examples, movement of the magnet within the slot indicates a magnetization state of rotor magnet within the rotor.

In some examples, receiving the motor rotor in the sleeve comprises engaging one or more notches of the motor rotor with one or more projections, e.g., blocks, of the sleeve, or vice versa. The engagement locates the motor rotor relative to the sleeve, e.g., in an axial and/or radial location.

In some examples, the method provides the visual indication based on a rotational position of the disc around the sleeve. The visual indication enables a user or operator to perform an instant checking of the polarity of a motor rotor, which reduces time and effort to perform the overall operation as compared to the conventional methods. As a result, the overall user experience is enhanced.

In some examples, the method further comprises providing the visual indication based on an axial position of the disc along the sleeve.

In some examples, the method comprises identifying the one or more polarity markings using a computer vision system.

In some examples, a kit of parts may be provided, the kit comprising multiple sleeves and multiple discs. For example, each of the multiple sleeves may be configured (e.g., sized and/or shaped) to receive a specific rotor. In a similar manner, each of the multiple discs may be configured to receive a specific sleeve or set of sleeves (e.g., a set of sleeves having a common outer diameter but different inner diameters, accounting for different rotor outer diameters). Additionally or alternatively, each of the multiple discs may have a differently configured indication assembly, accounting for rotors having different numbers of magnetic poles.

For the avoidance of doubt, the below examples may use the term "polarity" or "polarized" when referring to the checking the magnets of the rotor. However, disclosure should not be understood as limited to checking the "polarity" or "polarization" of the rotor magnet. Instead, the terms may be expanded to the general term "magnetization". For example, where technically possible, the claimed apparatus, method and system may be used to check magnetic field strength and/or a magnetic vector orientation, e.g., by virtue of an orientation of a slot and/or a moveable magnet within the slot. Additionally or alternatively, movement of the moveable magnet may be biased (and/or otherwise impeded, e.g., by friction). In some examples, the interaction between a moveable magnet and a rotor magnet may cause a magnetic force to act on the moveable magnet, that force acting against a bias force (and/or frictional force) acting on the moveable magnet in the slot.

### Brief Description of the Drawings

The above and other objects and advantages of the disclosure will be apparent upon consideration of the following detailed description, taken in conjunction with the accompanying drawings, in which like reference characters refer to like parts throughout, and in which:
FIG. 1 illustrates an apparatus, in accordance with some examples of the present disclosure;
FIG. 2 illustrates a sleeve, in accordance with some examples of the present disclosure;
FIG. 3A illustrates a back side of a disc, in accordance with some examples of the present disclosure;
FIG. 3B illustrates a front side of a disc, in accordance with some examples of the present disclosure;
FIG. 3C illustrates a cross-sectional perspective view of a disc, in accordance with some examples of the present disclosure; and
FIG. 4 illustrates a flowchart of a method, in accordance with some examples of the present disclosure.

### Detailed Description

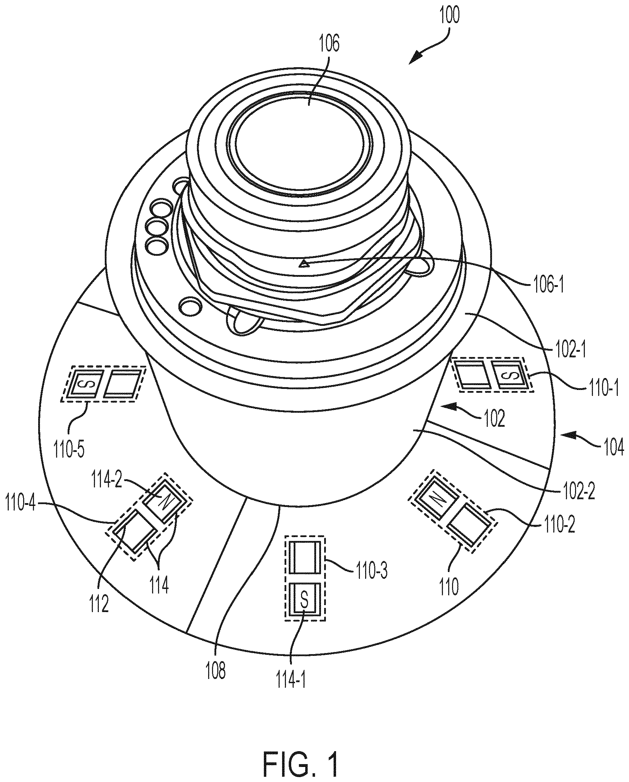

FIG. 1 illustrates an apparatus 100, in accordance with some examples of the present disclosure. The apparatus 100 comprises a sleeve 102 and a disc 104.

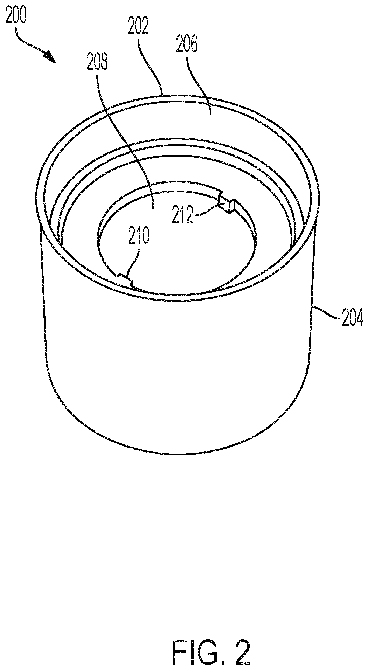

The sleeve 102 is configured to receive a motor rotor 106. A triangle mark 106-1 on the motor rotor 106 indicates the location of pole 1 of the motor rotor 106. The sleeve 102 is of a cylindrical shape. Alternatively, the sleeve 102 may be of different shapes. The sleeve 102 includes an upper end 102-1 and a lower end 102-2. The upper end 102-1 and the lower end 102-2 of the sleeve 102 are circular in shape. Alternatively, the upper end 102-1 and the lower end 102-2 of the sleeve 102 may be of different shapes. The sleeve 102 prevents pollutants such as dust from entering the motor rotor 106 during operation, which maintains the condition of the motor rotor 106 during a checking procedure. A complete structure of the sleeve 102 is illustrated in detail in FIG. 2.

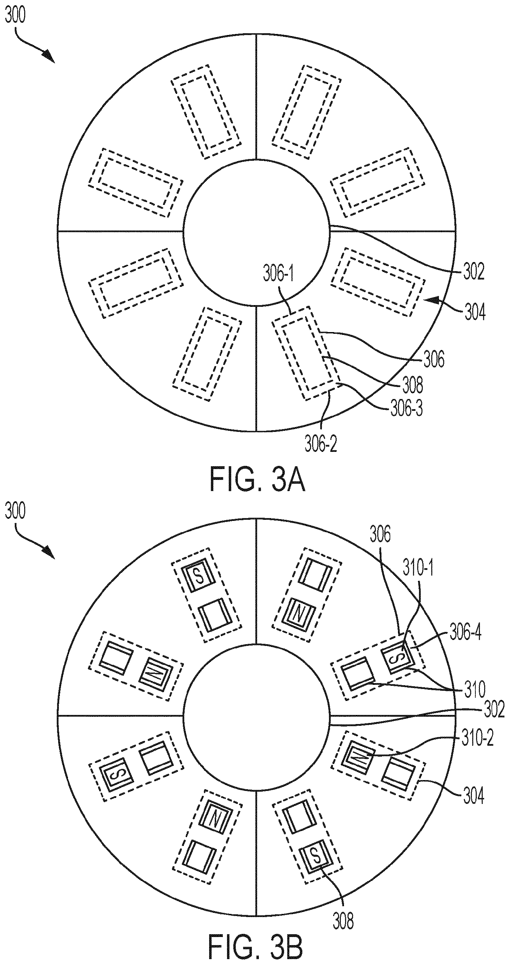

The disc 104 comprises a cavity 108 and an indication assembly 110. The cavity 108 receives the sleeve 102. The indication assembly 110 is arranged on the periphery of the cavity 108. The disc 104 is of circular shape. Alternatively, the disc 104 may be of different shapes. The indication assembly 110 is a combination of a slot (clearly shown in FIG. 3A-FIG. 3C), a moveable magnet 112 (partially visible), and one or more indication windows 114. The moveable magnet 112 may be a permanent magnet, e.g., a weak permanent magnet or a rare-earth magnet. In some examples, the shape, size and/or strength of the moveable magnet 112 may be selected depending on the configuration of the apparatus 100 and/or the motor rotor 106. The disc 104 includes multiple indication assemblies (110-1, 110-2, 110-3, 110-4, and 110-5), as shown in FIG. 1. Although, five indication assemblies are visible in FIG. 1, the disc 104 may further include but is not limited to a group of two, four, six or eight indication assemblies. In one example, the number of the indication assemblies is the same as the number of the poles of the motor rotor 106. For example, when checking the magnetization of a rotor having 6 poles, a disc having six indication assemblies may be selected from a set of discs each having a different number and/or configuration of indication assemblies (not shown). In another case, the number of the indication assemblies is multiple of the number of the poles of the motor rotor 106 to be indicated. The number of the indication assemblies (110-1,110-2, 110-3, 110-4, and 110-5) is uniformly arranged around the cavity 108. The indication assembly 110 includes a slot (clearly shown in FIG. 3A-FIG. 3C) to receive a moveable magnet 112 (partially visible). The moveable magnet 112 comprises one or more markings 114-1, and 114-2 on one or more indication windows 114 to visually indicate a magnetization state, e.g., a polarity of the motor rotor 106. The one or more indication windows 114 on the disc 104 indicates the polarity of the moveable magnet 112 of the motor rotor 106. The polarity markings 114-1, and 114-2 are north-south (N-S) markings. Alternatively, the polarity markings 114-1, and 114-2 may be highlighted in alternative red and green colours or using computer-readable tags. In one case, the polarity markings 114-1, and 114-2 are visible to a user or operator. In another case, the one or more polarity markings 114-1, and 114-2 are identified using a computer vision system. The disc 104 is rotatable at different angles with respect to the sleeve 102. For example, a motor rotor 106 having 8 poles, the disc 104 is positioned normally or rotated at 45 degrees to indicate the magnetization of each pole of the motor rotor 106. A complete structure of the disc 104 is illustrated in detail in FIG. 3A and FIG. 3B.

In some examples, a kit of parts may be provided, the kit comprising multiple sleeves and multiple discs. For example, each of the multiple sleeves may be configured (e.g., sized and/or shaped) to receive a specific rotor. In a similar manner, each of the multiple discs may be configured to receive a specific sleeve or set of sleeves (e.g., a set of sleeves having a common outer diameter but different inner diameters, accounting for different rotor outer diameters). Additionally or alternatively, each of the multiple discs may have a differently configured indication assembly, accounting for rotors having different numbers of magnetic poles.

In one example, an apparatus 100 (complete unit) is installed on an assembly line to automatically indicate a magnetization state, e.g., one or more polarity markings 114-1, and 114-2 of a moveable magnet 112 of a motor rotor 106. The structure and the operation of the apparatus 100 installed on the assembly line are the same as described above. The apparatus 100 is communicatively coupled to a computer vision system for automatic identification of the magnetization state of the motor rotor 106. The computer vision system further includes, but is not limited to a camera module, a processing module, a memory module, and a display module. The camera module scans or captures the one or more polarity markings 114-1, and 114-2 based on instructions received from the processing module. The instructions are stored in the memory module. The memory module is connected to the processing module, the camera module, and the display module via a bus. The processing module performs different operations on the scanned or captured one or more polarity markings 114-1, and 114-2and transmits the human-readable output to the display module. The display module displays the current magnetization state, e.g., the one or more polarity markings 114-1, and 114-2 of the motor rotor 106. The display module may also receive the input from the user or operator to perform a desired operation.

FIG. 2 illustrates a sleeve 200, in accordance with some examples of the present disclosure. The sleeve 200 is of cylindrical shape, including an upper end 202 and a lower end 204. The upper end 202 includes a hollow recess 206, circular in shape to receive the motor rotor (as shown in FIG. 1). The lower end 204 includes a hollow recess 208, circular in shape. The diameter of the hollow recesses 206 and 208 are configured to engage to outer diameters of the motor rotor . The inner diameter of the sleeve 200 are sized/ or shaped according to the diameter of the motor rotor. The outer diameter of the sleeve 200 may be sized/or shaped to match an internal size and/or shape of the cavity of a disc. In some examples, the inner diameter of the sleeve 200 is varied between different sleeves according to the outer diameter of the motor rotor. The hollow recess 208 of the lower end 204 includes one or more projections, e.g., blocks 210, and 212 aligned opposite to each other. However, any appropriate number of blocks may be provided in any appropriate positions. The one or more blocks 210, and 212 engage with one or more notches (not shown here) of the motor rotor. The engagement locates the motor rotor relative to the sleeve 202 (and locates the triangle mark 106-1 (as shown in FIG. 1) at an expected position of Pole 1 of the rotor), restricts the movement of the motor rotor and securely places the motor rotor at the lower end 204 of the sleeve 200. The sleeve 200 is detachably connected to a disc (not shown here). The sleeve may receive the motor rotor longitudinally or lengthwise.

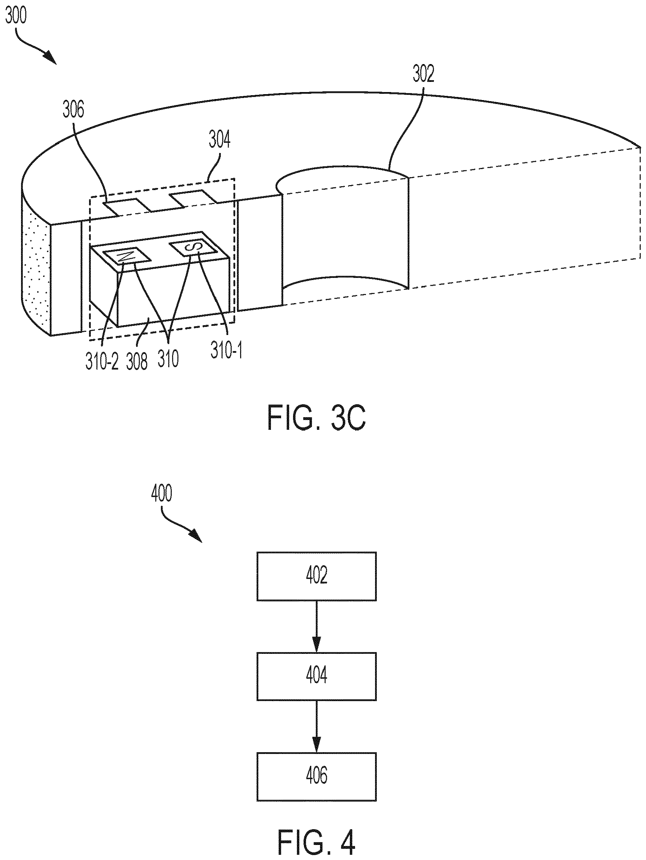

FIG. 3A and FIG. 3B illustrates a back side and a front side of a disc 300 respectively, in accordance with some examples of the present disclosure. The disc 300 includes a cavity 302, and an indication assembly 304. The cavity 302 is configured to receive the sleeve (shown in FIG. 1). The cavity 302 is circular in shape. Alternatively, the cavity 302 may be of different shapes, e.g., to match differently shaped sleeve/motor rotors. The indication assembly 304 is arranged on the periphery of the cavity 302. The indication assembly 110 is a combination of a slot 306, a moveable magnet 112 (partially visible), and one or more indication windows 114. The indication assembly 304 includes the slot 306 to receive the moveable magnet 308. The moveable magnet 308 may be a permanent magnet, e.g., a weak permanent magnet or a rare-earth magnet. In some examples, the shape, size and/or strength of the moveable magnet 308 may be selected depending on the configuration of the apparatus and/or the motor rotor (as shown in FIG. 1). The slot 306 includes an inner end 306-1 and an outer end 306-2. The inner end 306-1 is arranged in proximity to the cavity 302. The outer end 306-2 is arranged distant from the cavity 302. The slot 306 enables the moveable magnet 308 to move from the inner end 306-1 to the outer end 306-2. The slot 306 includes a lower end 306-3 to place the moveable magnet 308 and an upper end 306-4 (shown in FIG. 3B). The upper end 306-4 of the slot 306 comprises the one or more indication windows 310 to enable visibility of the one or more polarity markings 310-1 and 310-2 of the moveable magnet 308. The moveable magnet 308 is clearly visible in FIG. 3C.

FIG. 3C illustrates a cross-sectional perspective view of a disc 300, in accordance with some examples of the present disclosure. The placement and movement of a moveable magnet 308 in a slot 306, one or indication windows 310 in an upper end (shown in FIG. 3B), and the position of one or more polarity markings 310-1, 310-2 is clearly visible in FIG. 3C. A complete indication assembly 304 is shown in FIG. 3C.

In some examples, the motor rotor 106 may be fixed in position within the sleeve 102 and the disc 104 may be configured to move, e.g., rotationally and/or axially, relative to the sleeve 102. In this manner, the magnetization of magnets contained within the motor can be checked by moving the disc 104 relative to the sleeve-rotor subassembly (102, 106) and observing movement of the moveable magnet 112 within the slot (clearly shown in FIG. 3A-FIG. 3C).

Referring back to FIG. 1, during operation, the sleeve 102 receives the motor rotor 106. One or more notches of the motor rotor 106 engage with one or more blocks of the sleeve 102. The cavity 108 of the disc 104 receives the sleeve 102. The polarity of the motor rotor 106 at different instances along the entire length is variable or offset. To indicate the exact polarity of the motor rotor 106, the disc 104 is slid between the upper end 102-1 and the lower end 102-2 of the sleeve 102. If the disc 104 is slid over the surface of the sleeve 102, the polarity of the moveable magnet 112 is either changed or remains unaffected. The polarity of the moveable magnet 112 is indicated via the one or more indication windows 114 on the indication assembly 110. If the disc 104 is placed normally or rotated at 45 degrees around the sleeve 102 holding the motor rotor 106 and the moveable magnet 112 remains unaffected, this indicates that the motor rotor 106 is not magnetized. If the disc 104 is placed normally or rotated at 45 degrees around the sleeve 102 holding the motor rotor 106 and the moveable magnet 112 moves by the virtue of magnetic field of the motor rotor 106, this indicates that the motor rotor 106 is magnetized. Further, the one or more indication windows 114 are arranged on the disc 104 in such a way that the one or polarity markings 114-1 and 114-2 indicate the exact polarity of the motor rotor 106. If the polarity of the inner end (shown in FIG. 3A and FIG. 3B) of the moveable magnet 112 is different from the polarity of the motor rotor 106, the motor rotor 106 attracts the moveable magnet 112. The disc 104 works on the basic principle of magnetism. The one or more or more indication windows 114 are arranged on the disc 104 in such a way that the polarity markings 114-1 and 114-2 indicate a polarity opposite to the polarity of the moveable magnet 112 at the inner end after magnetic attraction. The one or more indication windows 114 are arranged on the disc 104 indicates the opposite or transpose of the polarity of the moveable magnet 112 after magnetic attraction, e.g., to indicate the polarity of the pole of the rotor. If the polarity of the inner end (shown in FIG. 3A and FIG. 3B) of the moveable magnet 112 has the same polarity as the motor rotor 106, the motor rotor 106 repels the moveable magnet 112. The one or more or more indication windows 114 are arranged on the disc 104 in such a way that the polarity markings 114-1 and 114-2 indicate a polarity same as the polarity of the moveable magnet 112 at the inner end after magnetic repulsion. The polarity markings 114-1 and 114-2 indicate the exact polarity of the motor rotor 106 after magnetic attraction or repulsion.

In one example, the polarity of the first pole of the motor rotor 106 is north and the polarity of the inner end of the moveable magnet 112 is south. The first north pole of the motor rotor 106 attracts the inner end of the moveable magnet 112. The moveable magnet 112 indicates the opposite or transpose of the polarity of the moveable magnet 112 after magnetic attraction through the one or more indication windows. The moveable magnet 112 shows the north pole on the one or more indication windows 114 on the disc 104 that matches with the polarity of the first pole at a surface of the motor rotor 106.

In another example, the polarity of the first pole of the motor rotor 106 is north and the polarity of the inner end of the moveable magnet 112 is north. The first north pole of the motor rotor 106 repels the inner end of the moveable magnet 112. The moveable magnet 112 indicates the same polarity as the moveable magnet 112 after magnetic repulsion. The moveable magnet 112 shows the north pole on the one or more indication windows 114 on the disc 104 that matches with the polarity of the first pole of the motor rotor 106. In view of the above, when the disc is rotated about the sleeve at a certain axial position, e.g., from 0 degrees to 45 degrees to 90 degrees, etc., the moveable magnet move radially along the slots so as to display in the indication window the pole of the rotor at each rotational position around the rotor.

FIG. 4 illustrates flowchart 400 of a method, in accordance with some examples of the present disclosure. The method 400 comprises receiving (402) a motor rotor in a sleeve; receiving (404) the sleeve in a cavity of a disc; and providing (406) a visual indication of polarity of the motor rotor using an indication assembly arranged on the periphery of the cavity; wherein the indication assembly includes a slot to receive a moveable magnet with one or more magnetization state, e.g., polarity markings.

The receiving (402) the motor rotor in the sleeve comprises engaging one or more notches of the motor rotor with one or more projections, e.g., blocks of the sleeve, or vice versa.

The method further comprises providing (406) the visual indication based on a rotational position of the disc around the sleeve. The visual indication enables a user or operator to perform an instant check of the polarity of a motor rotor, which reduces time and effort to perform the overall operation as compared to the conventional methods. As a result, the overall efficiency of checking the magnetization of the rotor is enhanced.

The method (400) further comprises providing (406) the visual indication based on an axial position of the disc.

The method further comprises identifying the one or more polarity markings using computer vision system.

The above-stated descriptions are merely example implementations of this application but are not intended to limit the protection scope of this application. A person with ordinary skills in the art may recognize substantially equivalent structures or substantially equivalent acts to achieve the same results in the same manner or a dissimilar manner; the exemplary embodiment should not be interpreted as limiting the disclosure to one embodiment.

While aspects of the present disclosure have been described in detail with reference to the illustrated embodiments, those skilled in the art will recognize that many modifications may be made thereto without departing from the scope of the present disclosure. The present disclosure is not limited to the precise construction and compositions disclosed herein; any and all modifications, changes, and variations apparent from the foregoing descriptions are within the spirit and scope of the disclosure as defined in the appended claims. Moreover, the present concepts expressly include any and all combinations and sub combinations of the preceding elements and features.

The description is provided for clarification purposes and is not limiting. Words and phrases are to be accorded their ordinary, plain meaning unless indicated otherwise.

## Claims

1. An apparatus comprising:
a sleeve to receive a motor rotor;
a disc comprising:
a cavity to receive the sleeve; and
an indication assembly arranged on the periphery of the cavity, including a slot to receive a moveable magnet, wherein the moveable magnet comprises one or more polarity markings to visually indicate polarity of the motor rotor.

2. The apparatus according to claim 1, wherein the slot includes an inner end arranged in proximity to the cavity and an outer end arranged distant from the cavity.

3. The apparatus according to claim 2, wherein the slot enables the moveable magnet to move from the inner end to the outer end.

4. The apparatus according to claim 3, wherein the movable magnet moves by virtue of magnetic field of the motor rotor.

5. The apparatus according to claim 1, wherein the slot includes a lower end to place the moveable magnet and an upper end.

6. The apparatus according to claim 5, wherein the upper end of the slot comprises one or more indication windows to enable visibility of the one or more polarity markings of the moveable magnet.

7. The apparatus according to preceding claims, wherein the indication window is arranged to indicate the polarity marking opposite to the polarity of the moveable magnet at the inner end, if the moveable magnet is attracted by the motor rotor.

8. The apparatus according to preceding claims, wherein the indication window is arranged to indicate the polarity marking same as the polarity of the moveable magnet at the inner end, if the moveable magnet is repelled by the motor rotor.

9. The apparatus according to claim 1, wherein the sleeve includes an upper end and a lower end to receive and enclose the motor rotor lengthwise.

10. The apparatus according to claim 9, wherein the disc is slidable between the upper end and the lower end of the sleeve to enable visual indication of the polarity of the motor rotor lengthwise.

11. A method comprising:
receiving a motor rotor in a sleeve;
receiving the sleeve in a cavity of a disc; and
providing a visual indication of polarity of the motor rotor using an indication assembly arranged on the periphery of the cavity; wherein the indication assembly includes a slot to receive a moveable magnet with one or more polarity markings.

12. The method according to claim 11, wherein receiving the motor rotor in the sleeve comprises engaging one or more notches of the motor rotor with one or more projections of the sleeve.

13. The method according to claim 11 or 12, wherein the method further comprises providing the visual indication based on a rotational position of the disc around the sleeve.

14. The method according to any of claims 11-13, wherein the method further comprises providing the visual indication based on an axial position of the disc along the sleeve.

15. The method according to any of claims 11-14, the method comprising identifying the one or more polarity markings using a computer vision system.
